Europäisches Patentamt

European Patent Office

Office européen des brevets

(11) Veröffentlichungsnummer: **0 476 414 A2**

## EUROPÄISCHE PATENTANMELDUNG

(21) Anmeldenummer: **91114782.5**

(22) Anmeldetag: **03.09.91**

(51) Int. Cl.5: **H05K 9/00**

(30) Priorität: **18.09.90 DE 4029498**

(43) Veröffentlichungstag der Anmeldung:
**25.03.92 Patentblatt 92/13**

(84) Benannte Vertragsstaaten:
**DE FR GB**

(71) Anmelder: **VACUUMSCHMELZE GMBH**
**Grüner Weg 37 Postfach 2253**
**W-6450 Hanau 1(DE)**

(72) Erfinder: **Weber, Hartwin, Dr.**
**Westbahnhofstrasse 9 d**
**W-6450 Hanau 1(DE)**

(54) **Abschirmkabine mit tragendem Sandwich-Aufbau.**

(57) Kabine zur Abschirmung magnetischer oder elektromagnetischer Felder, die hochpermeable weichmagnetische Materialien enthalten, werden bisher als Fachwerkskonstruktionen ausgeführt, bei denen eine Trennung zwischen magnetischer Funktion und tragender Funktion gegeben ist. Der Grund hierfür liegt in der vorhandenen Spannungsempfindlichkeit der verwendeten hochpermeablen weichmagnetischen Materialien. Gemäß der Erfindung ist vorgesehen, diese Trennung zwischen weichmagnetischer und tragender Funktion aufzugeben. Dies ist möglich, wenn die Kabinen aus Sandwich-Strukturen zusammengesetzt werden, wobei das weichmagnetische Material kraftschlüssig in die Sandwich-Struktur eingebaut wird. Hierdurch wird das weichmagnetische Material in definierter Weise mechanisch beansprucht. Die Vorteile liegen in einer hohen Steifigkeit der Kabine sowie in einer Reduktion der Herstellungskosten durch Materialersparnis und einfachere Montage.

EP 0 476 414 A2

Rank Xerox (UK) Business Services

Die Erfindung betrifft eine Vorrichtung zur Abschirmung magnetischer und/oder elektromagnetischer Felder, die aus Paneelen zusammengesetzt ist, wobei die Paneelen in Schichtform aus weichmagnetischem Material mit einer Anfangspermeabilität von mehr als 3000 und weiteren metallischen und/oder nichtmetallischen Materialien aufgebaut sind.

Solche Vorrichtungen in Form begehbarer Kabinen sind aus der DE-OS 24 46 986 bekannt. Dort wird zunächst eine Kabine beschrieben, bei der auf eine mit Sperrholz verschalte Holzzelle vorfabrizierte schlußgeglühte Bleche einer weichmagnetischen Nickel-Eisen-Legierung geklebt werden. Als Nachteil dieser Bauweise wird angeführt, daß durch das Aufkleben der Abschirmbleche auf Sperrholz Verspannungen im hochempfindlichen Magnetmaterial auftreten, die zu einer Erniedrigung der Permeabilitätswerte führen.

Nach der in dieser Offenlegungsschrift angegebenen verbesserten Ausführungsform einer Abschirmkabine wird zunächst ein Traggerüst errichtet, wobei alle Träger miteinander verschraubt werden. Das Gerüst wird dann innenseitig mit Tiefziehblechen verkleidet, um möglichst plane Wandflächen zu erhalten. Die eigentlichen Abschirmbleche bestehen vorzugsweise aus einer Nickel-Eisen-Legierung, die 70 bis 82 Gew.-% Nickel, 0 bis 11 Gew.-% Kupfer, 0 bis 6 Gew.-% Molybdän, 0 bis 6 Gew.-% Chrom, Rest Eisen, enthält, wobei der Eisengehalt mindestens 9 Gew.-% beträgt. Die Abschirmbleche mit den beispielhaften Abmessungen von 2500 mm x 380 mm x 2 mm wurden vorgefertigt und in einem Glühofen schlußgeglüht. Mit diesen Blechen wurden dann die Wände, die Decke und der Boden des abzuschirmenden Raumes kreuzweise belegt. Die beiden so erhaltenen Teilschichtsysteme aus dem magnetischen Abschirmmaterial wurden dann mittels Hohlblindnieten an den Tiefziehblechen befestigt. Hierdurch soll eine schonende Verbindung der hochpermeablen Abschirmbleche erreicht werden.

In der Veröffentlichung von K. J. Best und J. Bork in ETZ, Band 110 (1989), H. 16, S. 814 ff., sind weitere Abschirmkabinen beschrieben, denen das Prinzip der kreuzweise verlegten Teilschichtsysteme aus hochpermeablem magnetischem Material zugrunde liegt. Bei der dort beschriebenen dreischaligen Standardkabine werden unterschiedliche Werkstoffe verwendet, wobei die einzelnen Schalen aus hochpermeablem magnetischem Material und elektrisch hochleitfähigem Material (Aluminium) bestehen. Die magnetischen Wände sind dabei aus großen Tafeln (sogen. Paneelen) aufgebaut, die aus den oben bereits beschriebenen kreuzweise überlappenden Streifen aus magnetischem Material bestehen. Die gesamte Konstruktion wird wiederum durch ein Gerüst aus Leichtbauträgern gehalten.

Auch hier wird betont, daß das hochpermeable magnetische Material vor mechanischer Überbeanspruchung geschützt werden muß.

Als Sonderprojekt wird in der gleichen Veröffentlichung eine Abschirmkabine beschrieben, die einen siebenschaligen Aufbau aufweist, wobei die sechs äußeren Schalen aus MUMETALL und die innere Schale aus Kupfer besteht. Bei dieser Kabine wurde auf ein Trägersystem verzichtet. Die Schalen werden gegenseitig durch nicht-magnetische Zwischenlagen abgestützt.

Von besonderer Bedeutung bei Abschirmkabinen ist die Forderung nach möglichst großer Steife, besonders in dynamischer Hinsicht. Die Gründe liegen hierbei in der Vermeidung von Mikrophonie-Effekten durch Randschwingungen. Von Bedeutung ist jedoch auch die schwingungsfreie Aufhängung von Meßapparaturen, wie beispielsweise eines Squids mittels einer Halterung an der Kabinendekke. Dieser Aspekt gewinnt mit zunehmender Empfindlichkeit der Meßsysteme an Bedeutung.

Bei den von Best und Bork beschriebenen Abschirmkabinen wurde versucht, die bekannte Spannungsempfindlichkeit des weichmagnetischen Materials dadurch zu berücksichtigen, daß dieses möglichst von der tragenden Konstruktion getrennt wurde. Dies geschieht durch eine sogenannte "schwimmende" Befestigung, d. h. das Material wird nur lose mit der Konstruktion befestigt, beispielsweise durch Hohlblindnieten, wie dies in der diesen Abschirmkabinen zugrunde liegenden DE-OS 24 46 986 beschrieben ist. Hierdurch soll gewährleistet sein, daß das Material außer der Eigenlast mit keinen Zusatzbelastungen bzw. Momenten beaufschlagt wird. Die statische Aufgabe der Traglast wird von diskreten Trägerelementen bzw. von den nicht magnetischen Zwischenschichten erfüllt.

Aufgabe der Erfindung ist es, eine Kabine anzugeben, die aus vorgefertigten Paneelen zusammengesetzt ist, bei der eine möglichst große Steifigkeit der Kabine bei einfacher Montage und Reduktion der Herstellungskosten erzielt wird und die ohne ein Stützgerüst, das die statischen Aufgaben übernimmt, auskommt.

Die Aufgabe wird dadurch gelöst, daß die Paneelen in Sandwich-Bauweise mit einem Kern aus einem vorzugsweise wabenförmig strukturiertem Trägermaterial und mit mindestens einer kraftschlüssig in den Aufbau eingebrachten Schicht des weichmagnetischen Materials aufgebaut sind und daß die Paneelen tragend miteinander verbunden sind, so daß das weichmagnetische Material statische Aufgaben erfüllt und über die Belastung durch das Eigengewicht der Paneele hinaus mechanisch belastet wird.

Beim Bau von Abschirmkabinen gegen niederfrequente, niederohmige elektromagnetische Störungen werden hochpermeable Legierungen vorzugsweise des PERMALLOY-Typs eingesetzt. Es handelt sich hierbei um Nickel-Eisen-Basis-Legierungen, die 70 bis 82 Gew. % Nickel, mindestens 9 Gew.-% Eisen sowie bis zu 11 Gew.-% Kupfer, bis zu 6 Gew.-% Molybdän und bis zu 6 Gew.-% Chrom enthalten. Diese Legierungen weisen neben einer hohen Permeabilität auch eine vorhandene Spannungsempfindlichkeit der magnetischen Eigenschaften auf. Der Zusammenhang zwischen inneren Spannungen und der Permeabilität ist gegeben durch

$$\mu = Bs^2 / (9\,\pi \times \sigma_i \times \Delta\lambda),$$

wobei $\mu$ die Permeabilität, Bs die Sättigungsmagnetisierung, $\sigma_i$ die inneren Spannungen und $\Delta\lambda$ die Differenz der Magnetostriktionswerte in den jeweiligen kristallografischen Richtungen darstellen. Ein bekannter Vertreter dieser hochpermeablen Legierungen vom PERMALLOY-Typ ist eine unter dem Warenzeichen MUMETALL vertriebene Legierung mit einer Sättigungsinduktion Bs = 8000 Gauß sowie $\Delta\lambda = 2 \times 10^{-6}$. Bei Abschirmkabinen ist mit diesem Material eine Permeabiliät von 30 000 bis 50 000 erzielbar. Um diesen Wert zu erreichen, sollten daher die inneren Spannungen $\sigma_i$ nicht mehr als 3 N/mm$^2$ betragen. Größere Werte führen zur inneren Degradation der magnetischen Eigenschaften. Mit einem E-Modul von 200 000 N/mm$^2$ bedeutet dies eine maximale Dehnung von ca. $1 \times 10^{-5}$.

Überraschenderweise wurde nun gefunden, daß es trotz dieser Anforderungen und der bekannten Spannungsempfindlichkeit der magnetischen Eigenschaften dieser Materialien möglich ist, die bisher vorgenommene prinzipielle Trennung zwischen magnetischer Funktion und tragender Funktion bei Abschirmkabinen aufzugeben. Erfindungsgemäß wird das magnetische Material in die Konstruktion miteingebunden und erfüllt auch statische Funktionen. Der Erfindung liegt die Erkenntnis zugrunde, daß hochpermeable magnetische Materialien wie das beispielhaft genannte MUMETALL einen vergleichsweise hohen E-Modul bei gleichzeitig hoher mechanischer Dämpfung aufweisen. Bei den erfindungsgemäßen Abschirmkabinen werden daher vorzugsweise solche Magnetmaterialien eingesetzt, deren E-Modul größer als 170 000 N/mm$^2$ ist. Die Anfangspermeabilität ist vorzugsweise größer als 10 000. Bei gleicher räumlicher Ausdehnung von Werkstoff und Gewicht sind die erfindungsgemäßen Sandwich-Konstruktionen steifer im Vergleich zu herkömmlichen Fachwerkskonstruktionen. Bei den erfindungsgemäßen Abschirmkabinen wird das hochpermeable magnetische Material zwar mechanisch beansprucht, dies geschieht im Vergleich zu der Methode der "schwimmenden" Befestigung jedoch in einer definierten und damit voraussagbaren Weise. Der erfindungsgemäße Einsatz des weichmagnetischen Materials führt zu einer steiferen Kabine und/oder zu einer Reduktion der Herstellkosten durch Materialersparnis. Zusätzlich ergeben sich Kostenvorteile durch die einfache Montage bei Verwendung von Sandwich-Elementen.

Im folgenden wird die Erfindung anhand der Ausführungsbeispiele und der Zeichnungen näher erläutert. Es zeigen

Fig. 1       den Aufbau eines Sandwich-Elementes;

Fig. 2 und 3       Ausführungsbeispiele einer überlappenden Verbindung der Sandwich-Bauelemente.

Bekannte Sandwich-Strukturen bestehen in der Regel aus einem höher festen und hochelastischen Werkstoff als Deck-, (Gurt-) material, wie z. B. Aluminium-Legierungen, Stahl oder faserverstärkten Kunststoffen und einem leichten Kern aus Wabenstruktur von beispielsweise aluminiumgetränktem Papier, PU-Schaum, Styropor, Trapezblechen, Wellblechen, usw. . Sandwich-Strukturen weisen eine hohe Steifigkeit auf, so daß es erfindungsgemäß möglich ist, das für die beschriebenen Abschirmkabinen erforderliche hochpermeable Magnetmaterial kraftschlüssig in eine Sandwich-Struktur einzubauen, ohne daß der kritische Wert für innere Spannungen überschritten wird und ohne daß es zu einer inneren Degradation der magnetischen Eigenschaften kommt. Die kraftschlüssige Einbindung der Magnetmaterialien kann z. B. durch bekannte Ein- oder Zweikomponentenkleber sowie thermisch aktivierbare Folien erfolgen. Durch den hohen E-Modul der vorzugsweise verwendeten hochnickelhaltigen Magnetmaterialien vom PERMALLOY-Typ wird die Sandwich-Struktur zudem steifer und hierdurch die resultierende Beanspruchung noch geringer und unkritischer.

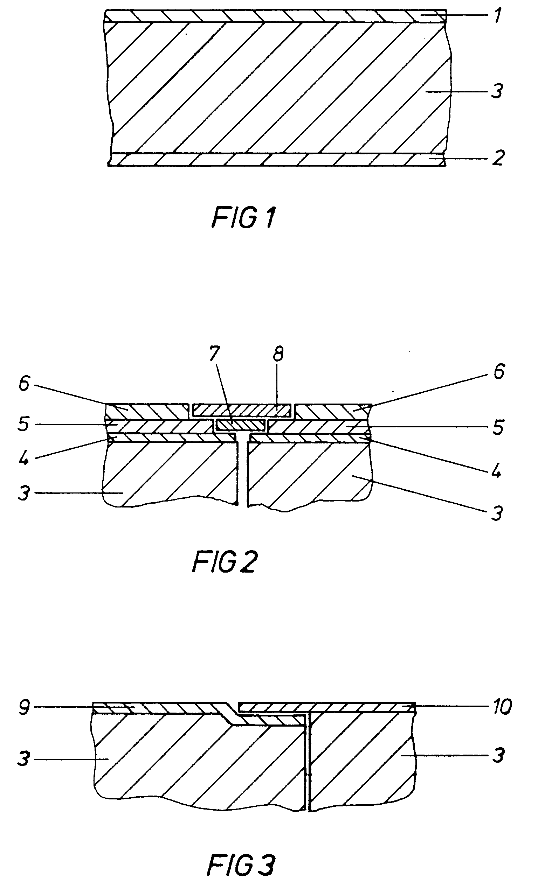

Eine solche Sandwich-Struktur ist in Fig. 1 dargestellt. Dabei sind Deckschichten 1, 2 auf einen Kern 3 aus einem leichteren Werkstoff als Trägermaterial kraftschlüssig aufgebracht. Bei Abschirmkabinen, die eine hohe Abschirmwirkung über einen größeren Frequenzbereich aufweisen sollen, kann es bekannterweise erforderlich sein, neben der magnetischen Abschirmung eine Leitfähigkeitsschale vorzusehen. Als geeignetes hochleitfähiges Material kommt vorzugsweise Aluminium, jedoch auch Kupfer in Frage. Die leitfähige Verbindung dieser Schichten der Sandwich-Elemente erfolgt in an sich bekannter Weise durch Schweißen bzw. Preßverbindungen. Ein Sandwich-Element mit leitfähiger Schicht kann beispielsweise so aufgebaut sein, daß die Schicht aus elektrisch hochleitfähigem Material zwischen dem Kern und der Schicht aus weichmagnetischem Material hoher Permeabilität angeordnet ist und daß die Schichten untereinander kraftschlüssig verbunden sind.

Gemäß einer weiteren bevorzugten Ausführungsform, die insbesondere dann vorteilhaft ist, wenn die Kabine ohne Leitfähigkeitsschale konstruiert wird, wird das hochpermeable Magnetmaterial direkt kraftschlüssig mit dem Kern aus Trägermaterial verbunden. Beim Zusammenbau der Kabine aus den einzelnen Paneelen ist zu beachten, daß der magnetische Schluß durch Überlappung von weichmagnetischen Deckschichten gewährleistet ist. Vorteilhafte Verbindungsmöglichkeiten sind in den Fig. 2 und 3 dargestellt. Bei der Ausführungsform gemäß Fig. 2 nimmt die Länge und/oder Breite der einzelnen Schichten 4, 5, 6 der Paneele vom Trägerkern 3 nach außen hin ab. In die verbleibenden Lücken werden Paßstücke 7 und 8 eingesetzt, die beispielsweise mit den Sandwich-Strukturen verklebt werden können. Besteht die Deckschicht nur aus einem Einzelblech, so kann die Verbindung gemäß Fig. 3 hergestellt werden. Hierbei weist die Deckschicht 9 der einen Paneele am Rande einen stufenförmigen Verlauf auf, während die Deckschicht 10 der benachbarten Paneele über das Trägermaterial 3 hinaus reicht und beim Zusammenfügen der Paneelen in die stufenförmige Einbuchtung der ersten Paneele hineinreicht und somit eine lückenlose Überlappung der Schichten gewährleistet ist.

**Patentansprüche**

1. Vorrichtung zur Abschirmung magnetischer und/oder elektromagnetischer Felder, die aus Paneelen zusammengesetzt ist, wobei die Paneelen in Schichtform aus weichmagnetischem Material mit einer Anfangspermeabilität von mehr als 3000 und weiteren metallischen und/oder nichtmetallischen Materialien aufgebaut sind, **dadurch gekennzeichnet**, daß die Paneelen in Sandwich-Bauweise mit einem Kern (3) aus einem vorzugsweise wabenförmig strukturierten Trägermaterial und mit mindestens einer kraftschlüssig in den Aufbau eingebrachten Schicht (1, 2) des weichmagnetischen Materials aufgebaut sind und daß die Paneelen tragend miteinander verbunden sind, so daß das weichmagnetische Material statische Aufgaben erfüllt und über die Belastung durch das Eigengewicht der Paneele hinaus mechanisch belastet wird.

2. Vorrichtung nach Anspruch 1, **dadurch gekennzeichnet**, daß das weichmagnetische Material einen E-Modul von mehr als 170 000 N/mm$^2$ aufweist.

3. Vorrichtung nach Anspruch 2, **dadurch gekennzeichnet**, daß das weichmagnetische Material aus einer Nickel-Eisen-Basislegierung besteht, die 70 - 82 Gew.% Nickel, mehr als 9 Gew.% Eisen sowie 0 - 11 Gew.% Kupfer, 0 - 6 Gew.% Molybdän und 0 - 6 Gew.% Chrom enthält.

4. Vorrichtung nach Anspruch 1, **dadurch gekennzeichnet**, daß die Schicht aus dem weichmagnetischen Material direkt kraftschlüssig mit dem Kern verbunden ist.

5. Vorrichtung nach Anspruch 1, **dadurch gekennzeichnet**, daß in der Sandwich-Struktur zumindest eine weitere Schicht aus elektrisch hochleitfähigem Material vorgesehen ist.

6. Vorrichtung nach Anspruch 5, **dadurch gekennzeichnet**, daß die Schicht aus elektrisch hochleitfähigem Material zwischen dem Kern und der Schicht aus dem weichmagnetischen Material hoher Permeabilität angeordnet ist und daß die Schichten untereinander kraftschlüssig verbunden sind.

7. Vorrichtung nach Anspruch 1, **dadurch gekennzeichnet**, daß die Länge und / oder Breite der einzelnen Schichten der Paneele vom Trägerkern nach außen hin abnimmt.

8. Vorrichtung nach Anspruch 1, **dadurch gekennzeichnet**, daß die weichmagnetische Schicht der Paneele mindestens einseitig am Randbereich einen stufenförmigen Verlauf aufweist, in den die weichmagnetische Schicht der benachbarten Paneele hineinreicht, so daß eine lückenlose Überlappung gewährleistet ist.

9. Vorrichtung nach Anspruch 1, **dadurch gekennzeichnet**, daß die Paneelen kraftschlüssig miteinander verbunden sind.

FIG 1

FIG 2

FIG 3